# EUROPEAN PATENT SPECIFICATION

(11) **EP 2 876 138 B1**
(45) Date of publication and mention of the grant of the patent: **10.01.2024**
(21) Application number: 14193750.8
(22) Date of filing: 18.11.2014
(51) Int. Cl.: C08L 83/04

(54) **Silicone material for protecting electronic devices, circuit module using the same and manufacturing method of circuit module**
Silikonmaterial zum Schutz elektronischer Vorrichtungen, Schaltmodul damit und Herstellungsverfahren des Schaltmoduls
Matériau silicone pour protéger des appareils électroniques, module de circuit l'utilisant et procédé de fabrication de module de circuit

(30) Priority: 20.11.2013 KR 20130141785
(43) Date of publication of application: 27.05.2015
(73) Proprietor: Samsung SDI Co., Ltd., Yongin-si, Gyeonggi-do (KR)
(72) Inventor: Shin, Kyungjae, Yongin-si, Gyeonggi-do (KR); Kim, Kiwoong, Yongin-si, Gyeonggi-do (KR)
(74) Representative: Marks & Clerk LLP

(56) References cited:
- WO-A1-2012/067153
- JP-A- 2004 012 810
- US-A- 6 099 783
- US-A1- 2012 135 251
- BAIKERIKAR K K ET AL: "Photopolymerizable liquid encapsulants for microelectronic devices", POLYMER, ELSEVIER SCIENCE PUBLISHERS B.V, GB, vol. 42, no. 2, 1 January 2001 (2001-01-01), pages 431-441, XP004216925, ISSN: 0032-3861, DOI: 10.1016/S0032-3861(00)00388-8

## Description

### BACKGROUND OF THE INVENTION

### 1. Field of the Invention

The present invention relates to a silicone material for protecting electronic devices, a circuit module using the same, and a manufacturing method of the circuit module.

### 2. Description of the Related Art

Silicone is used in almost every industrial field, covering general purposes and special purposes. In general, silicone is excellent in heat resistance and chemical resistance and has sealing, adhesiveness, connecting and foam controlling properties.

In general, a silicone for protecting an electronic device may include silicone for conformal coating for protecting the electronic device from external physical, chemical environments, damp-proofing silicone for preventing moisture from penetrating into the electronic device, vibration-absorbing silicone for preventing vibrations from being transferred to the electronic device, thermally conducting silicone for transmitting heat to the electronic device or discharging heat from the electronic device, ESD protecting silicone for protecting the electronic device from ESD, and so on.

Therefore, in order to protect the electronic device, steps of conformally coating silicone, damp-proofing silicone, vibration-absorbing silicone, thermally conducting silicone and ESD protecting silicone, are performed in sequence. Here, the conformally coating silicone, the damp-proofing silicone, the vibration-absorbing silicone, the thermally conducting silicone and the ESD protecting silicone generally have a curing time of approximately 30 minutes, respectively. That is to say, quite a long silicone curing time has conventionally been required.

Because different kinds of silicones are generally coated on the electronic devices in different process steps, the coating time is prolonged. In addition, separate trays and multiple coating apparatuses are required to transfer the circuit module to various processing stages. US 2012/135251 A1 and JP 2004 012810 A disclose silicone compositions.

### SUMMARY OF THE INVENTION

The present invention sets out to provide a silicone material that can overcome at least some of the above problems.

The invention is defined by the appended claims.

The circuit module may further include one or more wires electrically connected to the circuit patterns, and a wire fixing epoxy resin coated on connection regions between the circuit patterns and the wires.

At least one battery cell, at least one temperature sensor, or at least one connector may be electrically connected to the wires.

The electronic devices may include at least one selected from the group consisting of an integrated circuit semiconductor package, a transistor, a resistor, a capacitor, a positive temperature coefficient (PTC) element and a fuse.

According to still another embodiment of the present invention, there is provided a manufacturing method of a circuit module, including providing a printed circuit board having a plurality of circuit patterns formed on an insulating layer and electrically connecting a plurality of electronic devices to the circuit patterns by solders, coating the silicone material on at least one of the circuit patterns, the solders and the electronic devices, and curing the silicone material using light and heat.

The curing using light and heat may include controlling a wavelength of the light to be between 300 nm and 500 nm and controlling a temperature of the heat to be between 60°C and 100°C.

The curing using light and heat may be performed for 10 to 60 seconds.

In the electrically connecting of the plurality of electronic devices to the circuit patterns, the electronic devices may include at least one selected from the group consisting of an integrated circuit semiconductor package, a transistor, a resistor, a capacitor, a positive temperature coefficient (PTC) element and a fuse.

The electrically connecting of the plurality of electronic devices to the circuit patterns may further include electrically connecting one or more wires to the circuit patterns, and the manufacturing method may further include coating a wire fixing epoxy resin on connection regions between the circuit patterns and the wires, before the curing using light and heat.At least some of the above and other features of the invention are set out in the claims.

Therefore, a circuit module using the silicone material can achieve conformally coating, damp-proofing, vibration-absorbing, thermally conducting and ESD protecting functions following just a single coating step and a curing time of only 60 seconds (15 seconds in some cases). Consequently a manufacturing time of the circuit module can be considerably shortened.

Additional aspects and/or advantages of the invention will be set forth in part in the description which follows and, in part, will be obvious from the description, or may be learned by practice of the invention.

### BRIEF DESCRIPTION OF THE DRAWINGS

The objects, features and advantages of the present invention will be more apparent from the following detailed description in conjunction with the accompanying drawings, in which:
FIGS. 1A, 1B and 1C are a plan view, a bottom view and a partially cross-sectional view illustrating a circuit module having a silicone material for protecting electronic devices according to an embodiment of the present invention, coated thereon and cured;
FIG. 2 is a circuit view illustrating a state in which the circuit module having a silicone material for protecting electronic devices according to an embodiment of the present invention coated thereon and cured is electrically connected to a battery cell;
FIG. 3 is a flowchart illustrating a manufacturing method of a circuit module using a silicone material for protecting electronic devices according to an embodiment of the present invention; and
FIG. 4 schematically illustrates the manufacturing method of a circuit module using a silicone material for protecting electronic devices according to an embodiment of the present invention.
FIGs. 5A and 5B illustrate a high temperature and high humidity test condition of the circuit module using the silicone material for protecting electronic devices according to an embodiment.

### DETAILED DESCRIPTION

Hereinafter, an embodiment of the invention will be described in detail with reference to the accompanying drawings; however, the invention may be embodied in different forms and should not be construed as limited to the embodiments set forth herein. Rather, these embodiments are provided so that this disclosure will be thorough, and will convey the scope of the disclosure to those skilled in the art.

In the drawings, the thickness of layers and regions are exaggerated for clarity. Like numbers refer to like elements throughout. As used herein, the term "and/or" includes any and all combinations of one or more of the associated listed items.

The terminology used herein is for the purpose of describing particular embodiments only and is not intended to be limiting of the invention. As used herein, the singular forms are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that, although the terms first, second, etc. may be used herein to describe various members, elements, regions, layers and/or parts, these members, elements, regions, layers and/or parts should not be limited by these terms. These terms are only used to distinguish one member, element, region, layer and/or part from another member, element, region, layer and/or part. Thus, for example, a first member, element, region, layer and/or part discussed below could be termed a second member, element, region, layer and/or part without departing from the teachings of the present invention.

In addition, as used herein, the term "electronic device" may mean general active and passive devices, a circuit pattern, a solder, a wire, and so on. Further, as used herein, the term "circuit module" generally includes, but not limited to, a protection circuit module electrically connected to a battery cell, and other circuit modules used applied in various fields other than the battery field. Once a protection circuit module is electrically connected to a battery cell, the resulting structure may be referred to as a battery pack.

A silicone material for protecting electronic devices according to an embodiment of the present invention includes a base resin, a thermal initiator and a photoinitiator. In addition, the silicone material for protecting electronic devices according to an embodiment of the present invention may further include an ESD protecting filler and/or a thermally conductive filler.

The base resin includes at least one of polyurethane acrylate, isobonyl acrylate, modified acrylamide, hydroxy ethyl methacrylate, and equivalents thereof. However, the present invention does not limit the material of the base resin to those listed herein. The base resin basically has a conformally coating function, a damp-proofing function and a vibration-absorbing function.

In addition, the base resin is contained in an amount of 62 to 75 wt%, preferably about 63 to about 68 wt% based on a total weight (i.e., 100 wt%) of the silicone material. If the amount of the base resin is smaller than 62 wt%, the silicone material may have relatively high viscosity, preventing it from forming an adequate coating. If the amount of the base resin is greater than 75 wt%, the silicone material may have relatively low viscosity, and the silicone material may be overly mobile such that it flows on unwanted regions. That is to say, when the base resin is contained in an amount out of the range of from 62 to 75 wt%, workability of the silicone material may be lowered. In one embodiment, the present invention includes the base resin that contains the polyurethane acrylate in an amount of about 33 to about 38 wt%, the isobornyl acrylate in an amount of about 20 to about 24 wt%, and the modified acrylamide in an amount of about 9 to about 13 wt%.

The thermal initiator includes at least one of a silane coupling agent and an equivalent thereof. However, the present invention does not limit the material of the thermal initiator to those listed herein.

The thermal initiator is contained in an amount of from 4 to 5 wt%, preferably about 4.5 to about 5 wt%, based on a total weight (i.e., 100 wt%) of the silicone material. If the amount of the thermal initiator is smaller than 4 wt%, a thermally curing time of the silicone material is relatively long, and if the amount of the thermal initiator is greater than 5 wt%, an unnecessarily large amount of the thermal initiator is used, in view of the thermally curing time of the silicone material.

The photoinitiator is contained in an amount of from 8 to 10 wt%, preferably about 9 to about 10 wt%, based on a total weight (i.e., 100 wt%) of the silicone material. If the amount of the photoinitiator is smaller than 8 wt%, a photo-curing time of the silicone material is relatively long, and if the amount of the photoinitiator is greater than 10 wt%, an unnecessarily large amount of the photoinitiator is used, in view of the photo-curing time of the silicone material.

The ESD protecting filler includes at least one of aluminum oxide (Al₂O₃), aluminum hydroxide, tin dioxide (SnO₂), zinc oxide (ZnO) and equivalents thereof. In some cases, the thermally conductive filler to be described below may also have an ESD protecting function.

The thermally conductive filler includes at least one of fumed silica, magnesium oxide (MgO), boron nitride (BN), aluminum nitride (AIN) and equivalents thereof. In some cases, the above-described ESD protecting filler may also have a thermally conducting function.

The ESD protecting filler and the thermally conductive filler are contained in an amount of 22 to 32 wt%, preferably about 22 to about 23 wt%, or preferably about 26 to about 32 wt%, based on a total weight (i.e., 100 wt%) of the silicone material. If the amounts of the ESD protecting filler and the thermally conductive filler are smaller than 22 wt%, the silicone material may have relatively low viscosity, and the silicone material may be overly flowable to be coated even on unwanted regions. If the amounts of the ESD protecting filler and the thermally conductive filler are greater than 32 wt%, the silicone material may have relatively high viscosity, and the silicone material may not be properly coated. That is to say, when the ESD protecting filler and the thermally conductive filler are contained in an amount out of the range between 22 and 32 wt%, workability of the silicone material may be lowered. In one embodiment, the present invention includes the ESD protecting filler and the thermally conductive filler that contains the aluminum oxide (Al2O3) in an amount of about 10 to 12 wt%, the aluminum hydroxide (AIO) in an amount of about 15 to about 17 wt%, and the fumed silica in an amount of about 1 to about 3 wt%.

Here, the silicone material 130 according to the present invention for obtaining experimental results of tables 1 to 6 to be described below includes the polyurethane acrylate in an amount of about 33 to about 38 wt%, the isobornyl acrylate in an amount of about 20 to about 24 wt%, the modified acrylamide in an amount of about 9 to about 13 wt%, the silane coupling agent in an amount of about 4 to about 5 wt%, the photoinitiator in an amount of about 8 to about 10 wt%, the aluminum oxide (Al2O3) in an amount of about 10 to 12 wt%, the aluminum hydroxide (AIO) in an amount of about 15 to about 17 wt%, and the fumed silica in an amount of about 1 to about 3 wt%.

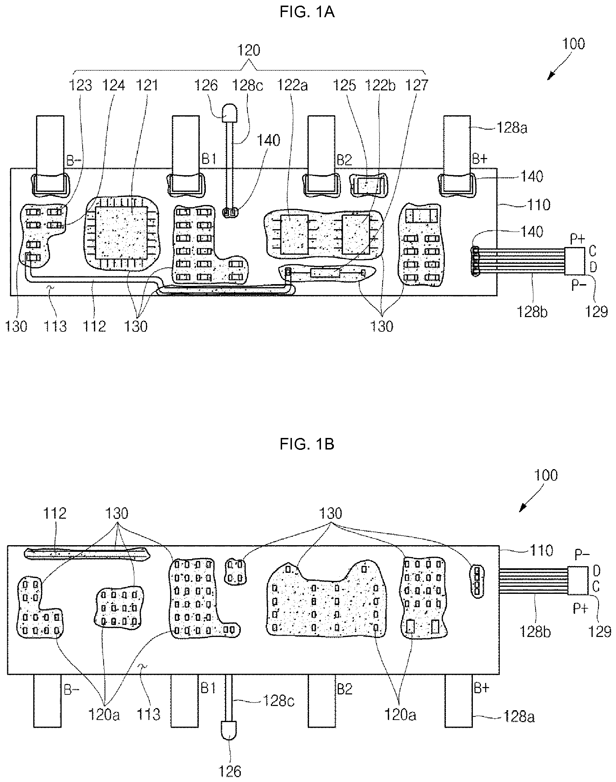

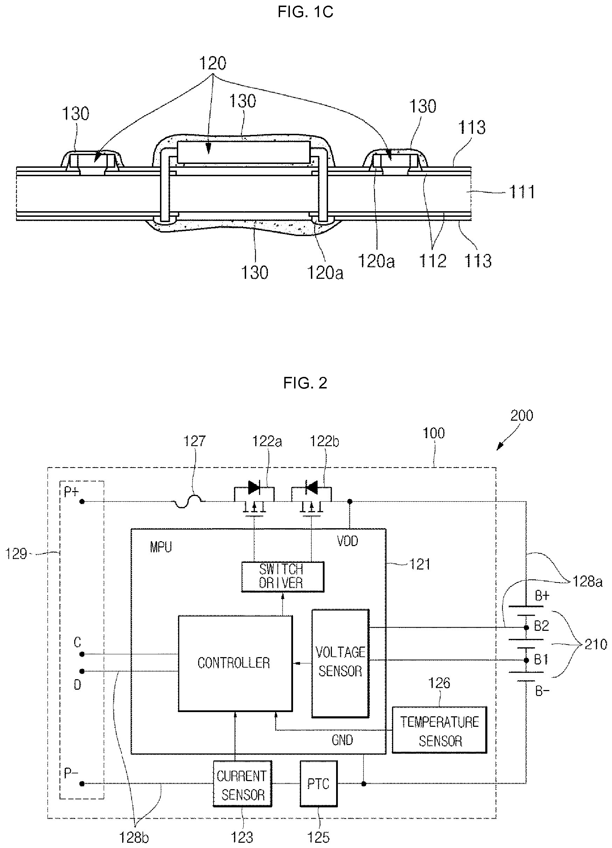

Referring to FIGS. 1A, 1B and 1C, a circuit module 100 having a silicone material 130 for protecting electronic devices according to an embodiment of the present invention, coated thereon and cured, is illustrated as a plan view, a bottom view and a partially cross-sectional view, respectively.

As illustrated in FIGS. 1A to 1C, the circuit module 100 according to an embodiment of the present invention includes a printed circuit board 110, a plurality of electronic devices 120 and a silicone material 130 coated on the circuit module 100 and cured.

The printed circuit board 110 includes a plurality of circuit patterns 112 formed thereon about an insulating layer 111, and most of the circuit patterns 112 are covered by a protection layer 113, such as a solder mask. The printed circuit board 110 may include at least one of a rigid circuit board, a flexible circuit board, and equivalents thereof.

The plurality of electronic devices 120 are electrically connected to the circuit patterns 112 provided in the printed circuit board 110 by solders 120a. For example, the electronic devices 120 include an integrated circuit (IC) semiconductor package 121, transistors 122a and 122b, a resistor 123, a capacitor 124, a positive temperature coefficient (PTC) element 125, a temperature sensor 126 and/or a fuse 127. Here, the IC semiconductor package 121 may be a microprocessor unit, and the transistors 122a and 122b may be a charge control switch and a discharge control switch, respectively.

In addition, one or more wires 128a, 128b and 128c may be electrically connected to the circuit patterns 112 provided in the printed circuit board 110 by the solders 120a. In an embodiment, the wire 128a may include a lead plate electrically connecting the circuit module 100 and a battery cell 210. In addition, the wire 128b may be connected to a connector 129 electrically connecting a battery pack 200 and an external set. Further, the wire 128c may be connected to the temperature sensor 126 for sensing a temperature of the battery cell 210.

Here, the circuit module 100 is provided by way of example only for a better understanding of the invention, so aspects of the present invention are not limited thereto.

Meanwhile, the silicone material 130 is coated on at least one of the circuit patterns 112, the solders 120a and the electronic devices 120 to then be cured. That is to say, the silicone material 130 has conformally coating, damp-proofing, vibration-absorbing, thermally conducting and ESD protecting functions. In other words, the silicone material 130 protects the circuit patterns 112, the solders 120a and/or the electronic devices 120 from external physical, chemical environments.

In more detail, the silicone material 130 prevents moisture from penetrating into the electronic devices 120. In addition, the silicone material 130 prevents vibrations from being transferred to the electronic devices 120. Further, the silicone material 130 allows the heat generated from the electronic devices 120 (e.g., the IC semiconductor package 121 and the transistors 122a and 122b) to be rapidly exhausted to the outside. In addition, the silicone material 130 allows temperatures of the battery cell 210 or surrounding portions thereof to be rapidly transferred to the electronic devices 120 (e.g., the PTC 125). For example, the silicone material 130 prevents static electricity from being introduced into the circuit patterns 112, the solders 120a and the electronic devices 120. The silicone material 130 may be white due to the filler contained therein, but the present invention does not limit the color of the silicone material 130 thereto. The silicone material 130 includes the base resin, the thermal initiator, the photoinitiator, the ESD protecting filler and/or the thermally conductive filler.

In addition, a wire fixing epoxy resin 140 may further be coated on connection regions (e.g., the solders 120a) between the circuit patterns 112 and the wires 128a, 128b and 128c. Here, the wire fixing epoxy resin 140 may be transparent so that its internal state can be observed, but aspects of the present invention are not limited thereto. The wire fixing epoxy resin 140 may be a general epoxy resin for fixing an electronic part, which has high adhesiveness, excellent workability and a quickly curing property.

Referring to FIG. 2, a circuit view illustrating a state in which the circuit module having a silicone material for protecting electronic devices according to an embodiment of the present invention coated thereon and cured is electrically connected to the battery cell 210, is illustrated.

As described above, the battery pack 200 includes at least one battery cell 210 and a protection circuit module for preventing the battery cell 210 from being overcharged or overdischarged. Here, the protection circuit module may be the above-described circuit module 100.

As illustrated in FIG. 2, the circuit module 100 may be electrically connected to the battery cell 210 through the wire 128a (or a lead plate or a flexible circuit board). In addition, the circuit module 100 may be electrically connected to the connector 129 through the wire 128b, and the connector 129 may be connected to an external set or a charger. The connector 129 may be directly mounted on the printed circuit board 110 without using a wire. In addition, the circuit module 100 may include the IC semiconductor package 121, the transistors 122a and 122b, the current sensor (e.g., the resistor 123), the PTC 125, the temperature sensor 126 and the fuse 127. Here, the circuit module 100 may be provided by way of example only for a better understanding of the invention, but the present invention does not limit the circuit module 100 to the circuit shown in FIG. 2.

Meanwhile, the battery cell 210 may be a general prismatic battery, a cylindrical battery, or a pouch type battery, but not limited thereto.

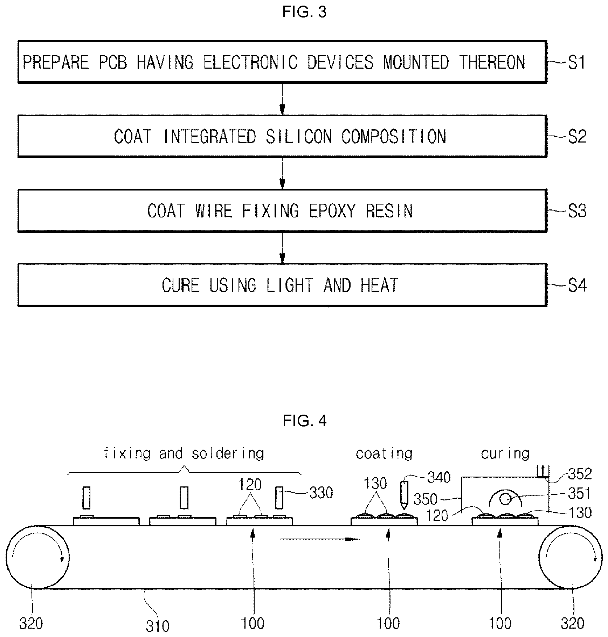

Referring to FIGS. 3 and 4, the manufacturing method of the circuit module 100 using the silicone material 130 for protecting electronic devices according to an embodiment of the present invention is illustrated. Here, FIGS. 1A to 1C are also referred to in describing the manufacturing method of the circuit module 100 using the silicone material 130 for protecting electronic devices according to an embodiment of the present invention.

The manufacturing method of the circuit module 100 according to an embodiment of the present invention may include: (S1) providing a printed circuit board; (S2) coating silicone material; and (S4) curing using light and heat. In addition, the manufacturing method of the circuit module 100 according to an embodiment of the present invention may include (S3) coating a wire fixing epoxy resin.

In step S1 of providing a printed circuit board, the printed circuit board 110 having the plurality of circuit patterns 112 is provided on the insulating layer 111, and the plurality of electronic devices 120 are electrically connected to the circuit patterns 112 by the solders 120a. Here, the electronic devices 120 may include the IC semiconductor package 121, the transistors 122a and 122b, the resistor 123, the PTC 125, the temperature sensor 126 and the fuse 127. Here, the wires 128a, 128b and 128c may be electrically connected to the printed circuit board 110 by the solders 120a.

In step S2 of coating silicone material, the silicone material 130 is coated on the circuit patterns 112, the solders 120a and/or the electronic devices 120. Here, as described above, the silicone material 130 has conformally coating, damp-proofing, vibration absorbing, thermally conducting and ESD protecting functions. Therefore, unlike in the conventional manufacturing method in which multiple process steps of coating conformally coating silicone, damp-proofing silicone, vibration-absorbing silicone, thermally conducting silicone and ESD protecting silicone, are performed in sequence, in the present invention, coating of the silicone material can be completed just by a single coating step of silicone material.

In addition, in step S3, the wire fixing epoxy resin 140 may further be coated on connection regions between the circuit patterns 112 and the wires 128a, 128b and 128c. Here, the wire fixing epoxy resin 140 may be a general UV curable resin.

In step S4 of curing using light and heat, the silicone material 130 is cured using light (e.g., UV light) and heat. Here, the wire fixing epoxy resin 140 may also be photo-cured.

Here, a wavelength of the light may be controlled to be between 300 nm and 500 nm and a temperature of the heat may be controlled to be between 60°C and 100°C. In addition, the curing using light and heat (S4) may be performed for 10 to 60 seconds. If the wavelength of the light is smaller than 300 nm or greater than 500 nm, photo-curing may not be properly performed. In addition, if the temperature is lower than 60°C, thermally curing may not be properly performed, and if the temperature is higher than 100°C, the electronic devices 120 may be damaged. Further, if the curing time is shorter than 10 seconds, the curing using light and/or heat may not be properly performed. If the curing time is longer than 60 seconds, an unnecessarily long curing time is taken.

Meanwhile, while the silicone material 130 is cured using light, a non-curing phenomenon may occur to shaded regions. However, as described above, the silicone material 130 may be cured by the heat generated form a light source 351, thereby shortening the overall curing time and demonstrating excellent curing performance.

Here, all of the process steps may be performed on a conveyor belt 310, which is coupled to a roller 320 and rotates in one direction. In addition, a tool 330 for fixing and soldering the electronic devices 120 and a cylinder 340 for coating the silicone material 130 are positioned on the conveyor belt 310. In addition, a chamber 350 including a light source 351 and an exhaust fan 352 for curing the silicone material 130 using light and heat may also be positioned on the conveyor belt 310.

In addition, an internal temperature of the chamber 350 where curing using light and curing using heat are performed may be controlled by the exhaust fan 352. That is to say. The light source 351 may increase the ambient temperature of the chamber 350 to be higher than 100°C, but the exhaust fan 352 may control the internal temperature of the chamber 350 to be between 60°C and 100°C.

Table 1 shows high temperature and high humidity test conditions. It was confirmed that corrosion did not occur to the electronic devices (i.e., the IC semiconductor package, the circuit patterns, the solders, etc. of the circuit module according to the present invention) under the high temperature and high humidity test conditions.

**Table 1**

| | Conditions | | |
|---|---|---|---|
| | Time | Humidity | Temperature |
| Salt water | 2hr | 5% | 20°C |
| Product No. 1 | 22hr | 93% | 40±2°C |
| Product No. 2 | 54hr | 85% | 50°C |

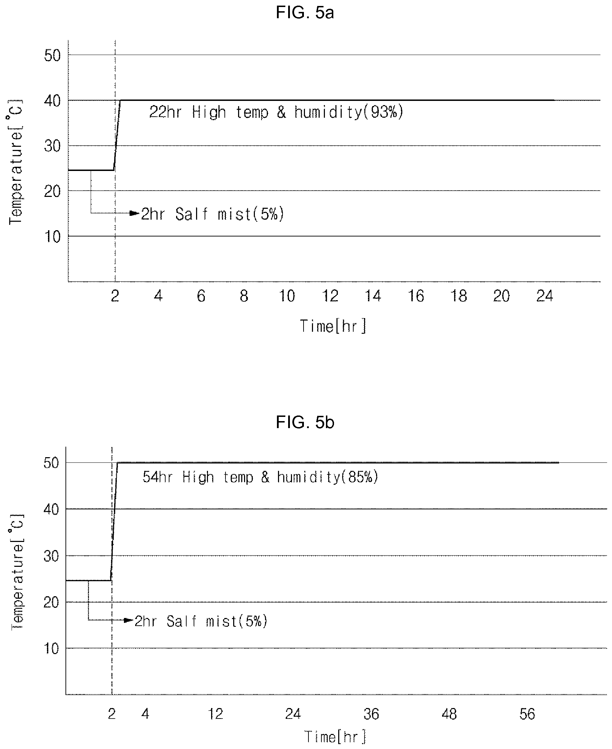

More specifically, after an injection to the circuit module (product NO.1) with salt water that has a salinity of 5 %, the circuit module (product NO.1) is allowed to stand for 2 hours at the humidity of 5 % and the temperature 20 °C. And then, as shown FIG. 5A, the circuit module as in the above (product NO.1) is allowed to stand for 22 hours at the humidity of 93 % and the temperature 40 ± 2 °C.

Further, after an injection to the circuit module (product NO.2) with salt water that has a salinity of 5 %, the circuit module (product NO.2) is allowed to stand for 2 hours at the humidity of 5% and the temperature 20 °C. And then, as shown FIG. 5B, the circuit module as in the above (product NO.2) is allowed to stand for 54 hours at the humidity of 85 % and the temperature 50 °C.

Table 2 shows ESD test conditions. It was confirmed that the circuit module according to the present invention was not electrically damaged under the ESD test conditions. In Table 2, the term "prior art" refers to a circuit module separate experiencing multiple process steps of conformally coating silicone, damp-proofing silicone, vibration-absorbing silicone, thermally conducting silicone and ESD protecting silicone. In addition, the term "contact" means that static electricity is applied in a state in which the static electricity is in contact with the electronic device, and the term "air" means that static electricity is applied in a state in which the static electricity is spaced apart from the electronic device.

For example, in the Comparative Example, 1-2577LV of the Dow Corning ^{®} has been applied to the circuit modules for the conformal coating, ES2031W of Canada Silicone INC. has been applied to the circuit modules for the thermal conductivity coating, and SE9189L of Dow Corning ^{®} has been applied to the circuit modules for the antistatic coating.

**Table 2**

| | | -8kV | -10kV | -12kV | -15kV | -17kV | -19kV |
|---|---|---|---|---|---|---|---|
| Prior Art | Contact | Pass | Pass | Pass | - | - | - |
| | Air | - | - | - | Pass | Pass | Pass |
| Present Invention | Contact | Pass | Pass | Pass | - | - | - |
| | Air | - | - | - | Pass | Pass | Pass |

Table 3 shows detection results of harmful substance from the inventive circuit module, specifically, the silicone material. As shown in Table 3, no harmful substance was detected from the inventive silicone material. Here, (X-Ray flourescence spectrometry (XRF) was used in detecting the harmful substance.

**Table 3**

| | | | | | | | |
|---|---|---|---|---|---|---|---|
| List | Cd | Pb | Hg | Cr | Sb | Br | Cl |
| Result | Pass | Pass | Pass | Pass | Pass | Pass | Pass |

Table 4 shows tensile strength test results of wires of the inventive circuit module. If each wire has a tensile strength of 1 kgf or greater, the wire is regarded as a normal wire.

**Table 4**

| | Product 1 | Product 2 | Product 3 | Product 4 | Product 5 |
|---|---|---|---|---|---|
| Wire 1 | 2.44 | 2.55 | 2.59 | 2.59 | 2.68 |
| Wire 3 | 5.98 | 6.4 | 5.89 | 6.12 | 5.49 |

Table 5 shows electrical function test results before and after battery packs each including the inventive circuit module is exposed to high temperature and high humidity conditions (50°C, 85%RH, 48hrs). In an embodiment, the OCV (open circuit voltage), IR, charge/discharge, communication, external appearance and leak status of the battery pack were all determined as being normal before and after the battery pack was exposed to the high temperature and high humidity conditions. Here, the OCV means a voltage of a battery cell when a current does not flow from the battery cell to the outside of the battery cell, and the IR means internal resistance of the battery cell. A ratio of OCV to IR (i.e., OCV/IR) is one of important factors in determining whether the battery pack is good or bad.

**Table 5**

| NO | Before testing | | | | | | After testing | | | | | | Result |
|---|---|---|---|---|---|---|---|---|---|---|---|---|---|
| | Function | | | | Ext. App. | Leak | Function | | | | Ext. App. | Leak | |
| | OCV | IR | C/D | Comm. | | | OCV | IR | C/D | Comm. | | | |
| 1 | 11.499 | 173.86 | OK | OK | OK | NO | 11.498 | 177.36 | OK | OK | OK | NO | OK |
| 2 | 11.497 | 169.80 | OK | OK | OK | NO | 11.494 | 170.20 | OK | OK | OK | NO | OK |
| 3 | 11.501 | 172.60 | OK | OK | OK | NO | 11.500 | 172.47 | OK | OK | OK | NO | OK |
| 4 | 11.499 | 171.58 | OK | OK | OK | NO | 11.498 | 169.81 | OK | OK | OK | NO | OK |
| 5 | 11.497 | 169.67 | OK | OK | OK | NO | 11.497 | 169.29 | OK | OK | OK | NO | OK |

| | | | | | | | | | | | | | |
|---|---|---|---|---|---|---|---|---|---|---|---|---|---|
| (C/D: Charge/Discharge; Comm.: Communication; Ext. App.: External Appearance; Leak: Leakage) | | | | | | | | | | | | | |

Table 6 shows electrical function test results before and after battery packs each including the inventive circuit module are exposed to ESD conditions (Contact: -8 kV; Air: -15 kV). In an embodiment, the OCV (open circuit voltage), IR, charge/discharge, communication, external appearance and leak status of the battery pack were all determined as being normal before and after the battery pack was exposed to the ESD conditions.

**Table 6**

| NO | Before testing | | | | | (+/-8KV) Contact | | | | | (+/-15KV) Air | | | | | Resu It |
|---|---|---|---|---|---|---|---|---|---|---|---|---|---|---|---|---|
| | Function | | | | Leak | Function | | | | Lea k | Leak | | | | Lea k | |
| | OCV | IR | C/D | Comm . | Fire leak | OCV | IR | C/D | Comm . | Fire leak | OC V | IR | C/D | Com m. | Fire leak | |
| 1 | 11.498 | 170.51 | OK | OK | OK | 11.49 9 | 1171.7 9 | OK | OK | OK | 11. 499 | 168.73 | OK | OK | OK | OK |
| 2 | 11.496 | 169.03 | OK | OK | OK | 11.49 6 | 167.4 3 | OK | OK | OK | 11. 496 | 168.36 | OK | OK | OK | OK |
| 3 | 11.505 | 167.72 | OK | OK | OK | 11.50 3 | 166.6 7 | OK | OK | OK | 11. 505 | 167.60 | OK | OK | OK | OK |
| 4 | 11.497 | 173.10 | OK | OK | OK | 11.49 7 | 171.1 9 | OK | OK | OK | 11. 498 | 170.30 | OK | OK | OK | OK |
| 5 | 11.505 | 172.88 | OK | OK | OK | 11.50 6 | 170.2 2 | OK | OK | OK | 11. 506 | 168.21 | OK | OK | OK | OK |

| | | | | | | | | | | | | | | | | |
|---|---|---|---|---|---|---|---|---|---|---|---|---|---|---|---|---|
| (C/D: Charge/Discharge; Comm.: Communication; Ext. App.: External Appearance; Leak: Leakage) | | | | | | | | | | | | | | | | |

As described above, an embodiment of the present invention provides a silicone material for protecting electronic devices, which has conformally coating, damp-proofing, vibration absorbing, thermally conducting and electrostatic discharge (ESD) protecting functions, and can be cured within 60 seconds, a circuit module using the same, and a manufacturing method of the circuit module.

In addition, the battery pack including the circuit module according to the embodiment of the present invention demonstrates normal OCV, IR, charge/discharge, communication, external appearance states and experiences no leakage even under the high temperature and high humidity/ESD conditions.

Therefore, a silicone material according to the embodiment of the present invention ensures normal electrical performance even under the high temperature and high humidity/ESD conditions while considerably reducing the manufacturing time of the circuit module (protection circuit module) and the battery pack including the same.

While the silicone material for protecting electronic devices, the circuit module using the same, and the manufacturing method of the circuit module according to the present invention have been described in connection with what is presently considered to be practical embodiments, it is to be understood that the invention is not limited to the disclosed embodiments, but, rather is intended to cover various modifications and equivalent arrangements included within the scope of the appended claims.

## Claims

1. Silicone material for protecting electronic devices, the silicone material comprising:
a base resin contained in an amount of 62 to 75 wt%, based on a total weight of the silicone material;
a thermal initiator comprising a silane coupling agent, wherein the thermal initiator is contained in an amount of 4 to 5 wt%, based on a total weight of the silicone material;
a photoinitiator contained in an amount of 8 to 10 wt%, based on a total weight of the silicone material;
an electrostatic discharge (ESD) protecting filler; and
a thermally conductive filler,
wherein the base resin includes at least one of: polyurethane acrylate, isobonyl acrylate, modified acrylamide and hydroxy ethyl methacrylate;
wherein the ESD protecting filler includes at least one of: aluminum oxide (Al₂O₃), aluminum hydroxide,
tin dioxide (SnO₂) and zinc oxide (ZnO),
wherein the thermally conductive filler includes at least one of: fumed silica, magnesium oxide (MgO), boron nitride (BN) and aluminum nitride (AIN), and
wherein the ESD protecting filler and the thermally conductive filler are contained in a combined amount of 22 to 32 wt%, based on a total weight of the silicone material.

2. A circuit module comprising:
a printed circuit board having a plurality of circuit patterns formed on an insulating layer;
a plurality of electronic devices electrically connected to the circuit patterns; and
silicone material according to claim 1, the silicone material being coated on at least one of the circuit patterns and the electronic devices.

3. A manufacturing method for a circuit module, the said method comprising:
providing a printed circuit board having a plurality of circuit patterns formed on an insulating layer and electrically connecting a plurality of electronic devices to the circuit patterns;
coating silicone material of claim 1 on at least one of the circuit patterns and the electronic devices; and
curing the silicone material using light and heat.

4. A manufacturing method according to claim 3, wherein the curing using light and heat comprises applying light having a wavelength of from 300 nm to 500 nm to the silicone material and controlling the temperature of the silicone material to be from 60°C to 100°C.

5. A manufacturing method according to claim 3 or 4, wherein the curing using light and heat is performed for a period of from 10 to 60 seconds.

## Patentansprüche

1. Silikonmaterial zum Schutz elektronischer Vorrichtungen, wobei das Silikonmaterial Folgendes umfasst:
ein Basisharz, das in einer Menge von 62 bis 75 Gew.-%, bezogen auf das Gesamtgewicht des Silikonmaterials, enthalten ist
einen thermischen Initiator, der ein Silankopplungsmittel umfasst, wobei der thermische Initiator in einer Menge von 4 bis 5 Gew.-%, bezogen auf das Gesamtgewicht des Siliconmaterials, enthalten ist;
einen Photoinitiator, der in einer Menge von 8 bis 10 Gew.-%, bezogen auf das Gesamtgewicht des Silikonmaterials, enthalten ist;
einen Füllstoff zum Schutz vor elektrostatischer Entladung (ESD); und
einen wärmeleitenden Füllstoff,
wobei das Basisharz mindestens eines der folgenden einschließt: Polyurethanacrylat, Isobonylacrylat, modifiziertes Acrylamid und Hydroxyethylmethacrylat;
wobei der ESD-schützende Füllstoff mindestens einen der folgenden Stoffe einschließt: Aluminiumoxid (Al₂O₃), Aluminiumhydroxid, Zinndioxid (SnO₂) und Zinkoxid (ZnO),
wobei der wärmeleitende Füllstoff mindestens einen der folgenden Stoffe einschließt: pyrogene Kieselsäure, Magnesiumoxid (MgO), Bornitrid (BN) und Aluminiumnitrid (AIN), und
wobei der ESD-schützende Füllstoff und der wärmeleitende Füllstoff in einer kombinierten Menge von 22 bis 32 Gew.-%, bezogen auf das Gesamtgewicht des Silikonmaterials, enthalten sind.

2. Schaltungsmodul, Folgendes umfassend:
eine gedruckte Leiterplatte, die eine Vielzahl von auf einer Isolierschicht gebildeten Schaltungsstrukturen aufweist;
eine Vielzahl von elektronischen Vorrichtungen, die elektrisch mit den Schaltungsstrukturen verbunden sind; und
Silikonmaterial nach Anspruch 1, wobei das Silikonmaterial auf mindestens eine der Schaltungsstrukturen und die elektronischen Vorrichtungen aufgetragen ist.

3. Herstellungsverfahren eines Schaltungsmoduls, wobei das Verfahren Folgendes umfasst:
Bereitstellen einer gedruckten Leiterplatte, die eine Vielzahl von auf einer Isolierschicht gebildeten Schaltungsstrukturen aufweist, und elektrisches Verbinden einer Vielzahl von elektronischen Vorrichtungen mit den Schaltungsstrukturen;
Auftragen des Silikonmaterials nach Anspruch 1 auf mindestens eine der Schaltungsstrukturen und die elektronischen Vorrichtungen; und
Aushärten des Silikonmaterials unter Verwendung von Licht und Wärme.

4. Herstellungsverfahren nach Anspruch 3, wobei die Härtung unter Verwendung von Licht und Wärme das Aufbringen von Licht mit einer Wellenlänge von 300 nm bis 500 nm auf das Silikonmaterial und die Steuerung der Temperatur des Silikonmaterials auf eine Temperatur von 60 °C bis 100 °C umfasst.

5. Verfahren nach Anspruch 3 oder 4, wobei die Härtung unter Verwendung von Licht und Wärme über einen Zeitraum von 10 bis 60 Sekunden durchgeführt wird.

## Revendications

1. Matériau silicone permettant de protéger des dispositifs électroniques, le matériau silicone comprenant :
une résine de base contenue en une quantité de 62 à 75 % en poids, rapporté au poids total du matériau silicone,
un amorceur thermique comprenant un agent de couplage silane, dans lequel l'amorceur thermique est contenu en une quantité de 4 à 5 % en poids rapporté au poids total du matériau silicone,
un photo-amorceur contenu en une quantité de 8 à 10 % en poids rapporté au poids total du matériau silicone,
une charge de protection contre les décharges électrostatiques (ESD), et
une charge thermiquement conductrice,
dans lequel la résine de base inclut au moins un des suivants : acrylate de polyuréthane, acrylate d'isobonyle, acrylamide modifié et (hydroxyéthyl)méthacrylate,
dans lequel la charge de protection contre les ESD inclut au moins un des suivants : oxyde d'aluminium (Al₂O₃), hydroxyde d'aluminium, dioxyde d'étain (SnO₂) et oxyde de zinc (ZnO),
dans lequel la charge thermiquement conductrice inclut au moins un des suivants : silice pyrogénée, oxyde de magnésium (MgO), nitrure de bore (BN) et nitrure d'aluminium (AIN), et
dans lequel la charge de protection contre les ESD et la charge thermiquement conductrice sont contenues en une quantité combinée de 22 à 32 % en poids rapporté au poids total du matériau silicone.

2. Module de circuit comprenant :
une carte à circuit imprimé présentant une pluralité de tracés de circuit sur une couche isolante,
une pluralité de dispositifs électroniques connectés électriquement aux tracés de circuit, et
un matériau silicone selon la revendication 1, le matériau silicone étant revêtu sur au moins l'un des tracés de circuits et des dispositifs électroniques.

3. Procédé de fabrication d'un module de circuit, ledit procédé comprenant :
la fourniture d'une carte à circuit imprimé présentant une pluralité de tracés de circuit formés sur une couche isolante et le fait de connecter électriquement une pluralité de dispositifs électroniques aux tracés de circuit,
le fait de revêtir le matériau silicone selon la revendication 1 sur au moins un des tracés de circuit et des dispositifs électroniques, et
le fait de faire durcir le matériau silicone en se servant de lumière et de chaleur.

4. Procédé de fabrication selon la revendication 3, dans lequel le durcissement en se servant de lumière et de chaleur comprend l'application de lumière ayant une longueur d'onde de 300 nm à 500 nm sur le matériau silicone et la régulation de la température du matériau silicone pour qu'elle vaille de 60 °C à 100 °C.

5. Procédé de fabrication selon la revendication 3 ou 4, dans lequel le durcissement en se servant de lumière et de chaleur est exécuté pendant une période de 10 à 60 secondes.
